(19) Europäisches Patentamt
European Patent Office
Office européen des brevets

(11) **EP 4 779 298 A1**

(12) **EUROPEAN PATENT APPLICATION**

(43) Date of publication:
**22.07.2026 Bulletin 2026/30**

(21) Application number: **25152466.6**

(22) Date of filing: **17.01.2025**

(51) International Patent Classification (IPC):
**G01N 24/08** (2006.01)   **G01R 33/28** (2006.01)
**G01R 33/44** (2006.01)   **G01R 33/46** (2006.01)
**G01R 33/30** (2006.01)   **G01R 33/465** (2006.01)

(52) Cooperative Patent Classification (CPC):
**G01R 33/282; G01N 24/088; G01R 33/445;**
**G01R 33/448; G01R 33/4608;** G01R 33/30;
G01R 33/465

(84) Designated Contracting States:
**AL AT BE BG CH CY CZ DE DK EE ES FI FR GB**
**GR HR HU IE IS IT LI LT LU LV MC ME MK MT NL**
**NO PL PT RO RS SE SI SK SM TR**
Designated Extension States:
**BA**
Designated Validation States:
**GE KH MA MD TN**

(71) Applicants:
• **Karlsruher Institut für Technologie, Körperschaft**
  **des öffentlichen Rechts**
  **76131 Karlsruhe (DE)**
• **ETH Zürich (Eidgenössische Technische**
  **Hochschule**
  **Zürich)**
  **8092 Zürich (CH)**

(72) Inventors:
• **Meier, Benno**
  **76133 Karlsruhe (DE)**

• **Gossert, Alvar Diego**
  **8037 Zürich (CH)**
• **Kouril, Karel**
  **76185 Karlsruhe (DE)**
• **Minaei, Masoud**
  **76137 Karlsruhe (DE)**
• **Safiullin, Kajum**
  **76131 Karlsruhe (DE)**
• **Narwal, Pooja**
  **76344 Eggenstein-Leopoldshafen (DE)**
• **Zasukhin, Dmitrii**
  **76133 Karlsruhe (DE)**
• **Lorz, Nils Bodo**
  **5000 Aarau (CH)**

(74) Representative: **Müller-Boré & Partner**
  **Patentanwälte PartG mbB**
  **Friedenheimer Brücke 21**
  **80639 München (DE)**

(54) **METHOD AND SYSTEM FOR SCREENING OF DRUG CANDIDATES BY MEANS OF NUCLEAR MAGNETIC RESONANCE**

(57)    The present invention relates to a method and system for drug screening by means of nuclear magnetic resonance, by determining binding affinity between a ligand and a target molecule. The method comprises

- preparing a sample (1) containing at least one ligand (L), the ligand being a putative drug candidate or a fragment thereof;

- hyperpolarizing the sample (1);

- performing, with the hyperpolarized sample (1), a nuclear magnetic resonance T1-measurement in presence of a drug target, wherein performing the nuclear magnetic resonance T1-measurement comprises performing a T1 evolution by keeping the sample at a low magnetic field for a variable evolution time, wherein the low magnetic field does not exceed 5 Tesla; and

determining binding data based on the nuclear magnetic resonance T1-measurement wherein the binding data comprises information about a binding of the ligand (L) to the drug target.

Fig. 3

EP 4 779 298 A1

**Description**

The present invention relates to a method and system for drug screening by means of nuclear magnetic resonance.

Drug screening refers to the process of testing and evaluating potential drug candidates to determine their efficacy, safety and/or pharmacological properties. It helps identify viable drug candidates while filtering out those that are ineffective and/or toxic. Thus, drug screening is particularly crucial for the drug industry.

It is well known that nuclear magnetic resonance (NMR) can be used for drug screening. In particular, drug screening comprises a detection and/or characterization of binding between a drug candidate (ligand) and a target molecule (receptor). Conventionally, NMR based drug screening is carried out by using a high magnetic field NMR instrument which provides a magnetic field of the order of 10 T (T = Tesla) and which costs of the order of 1 Mio EUR or more. For drug screening, an NMR observable parameter, such as the spin-spin relaxation rate and/or the rotational diffusion time constant ($\tau_c$) of a ligand molecule, is measured in the presence of a target molecule (also called drug target or receptor, which typically is a biomolecule such as a protein, RNA or DNA). One may also measure the change of the ligand NMR signal upon manipulating either water molecules (the so-called waterLOGSY experiment) or the protons of the target molecule (the saturation transfer difference or STD experiment) as a proxy for $\tau_c$. For NMR based drug screening, typically about 200 uM (uM = μmol per liter) of the ligand and about 20 uM of the protein are usually required. In particular, a single point measurement on $^1H$ or $^{19}F$ yields to a yes/no answer concerning a binding of the ligand to the protein. The measurement time by using conventional methods is about 10 to 20 minutes and thus relatively long.

It is a problem of the present invention to provide an improved method and system for NMR based drug screening. In particular, it is a problem of the present invention to provide a method and system for NMR based drug screening that is more efficient, faster and/or cheaper and/or that can probe binding by using significantly lower ligand and/or drug target concentrations. This problem is solved by the features of the independent claims. Preferred embodiments are defined in the dependent claims.

According to one aspect of the present invention, a method for drug screening by means of nuclear magnetic resonance is provided, the method comprising:

- preparing a sample containing at least one ligand, the ligand being a putative drug candidate or a fragment thereof;
- hyperpolarizing the sample (particularly nuclear spins of the at least one drug candidate);
- performing, with the hyperpolarized sample, a low-field nuclear magnetic resonance measurement; and
- determining binding data of the ligand based on the low-field nuclear magnetic resonance measurement.

The low-field nuclear magnetic resonance measurement with the hyperpolarized sample is particularly carried out in presence of the drug target. Preferably, the low-field nuclear magnetic resonance measurement is a low-field nuclear magnetic resonance $T_1$-measurement. $T_1$ is the longitudinal relaxation time compared to $T_2$ being the transversal relaxation time. In particular, $T_1$ is the time constant with which the longitudinal magnetization $M_z$ returns towards its thermal equilibrium value $M_0$, i.e. $dM_z/dt = -(M_z - M_0)/T_1$ (one of the so-called Bloch Equations). In other words, $T_1$ is the time it takes for the longitudinal magnetization (the net magnetization along the direction of the magnetic field) to return to equilibrium after being disturbed (for example by a radiofrequency pulse).

Within the present description, hyperpolarizing the sample means polarizing the sample far beyond thermal equilibrium conditions. In particular, a hyperpolarization is a spin polarization of the atomic nuclei of a material in a magnetic field far beyond thermal equilibrium condition (e.g. given by the Boltzmann distribution). In particular, within the present description, hyperpolarizing a sample means that the polarization levels are enhanced by a factor of at least $10^2$, preferably a factor of at least $10^3$, more preferably a factor of at least $10^4$, and particularly by a factor of $10^2$ to $10^6$ or a factor of $10^4$ to $10^6$, with respect to thermal equilibrium levels, particularly with respect to the thermal equilibrium at an NMR detection field. In particular, it is noted that merely polarizing the sample in a high magnetic field, for example in a magnetic field of the order of 10 T, would lead to only a 10-fold enhancement of the polarization level and thus does not fall under the term "hyperpolarization" in the sense of the present description. Within the present description, merely polarizing the sample in a (high) magnetic field rather means a "prepolarization" instead of a "hyperpolarization". Accordingly, hyperpolarizing a sample significantly differs from just polarizing or prepolarizing the sample (e.g. by merely placing the sample in a high magnetic field).

In NMR experiments without hyperpolarization, one can measure the time constant $T_1$ by first creating a non-equilibrium magnetization. This is done by either saturating the magnetization using RF pulses, or by inverting it (such that it points antiparallel to the applied field) using a 180-degree pulse or pi-pulse. The recovery of the magnetization can then either be monitored by so-called small flip angle pulses (which can be thought of as merely observing the sign and magnitude of the magnetization without perturbing it significantly), or by 90-degree or pi/2-pulses (which flip the entire magnetization into the xy-plane, giving rise to an NMR signal which is proportional to the magnetization along the z-axis prior to the pulse). In the latter case, one needs to repeat the experiment several times with increasing delays between the saturation/inversion state and the detection stage. In NMR experiments with hyperpolarization, the magnetization is larger than at thermal equilibrium, preferably by 2 to 6 orders of magnitude. In case of a hyperpolarization, it is possible to measure $T_1$ simply by observing the decay of the (large) magnetization, e.g. by using small flip angle pulses.

Within the present description, the term "binding data" particularly relates to data which can be used to determine whether a binding of the ligand (to a target molecule such as a protein and/or enzyme) takes place or not. In particular, determining binding data comprises or means determining whether a binding of the ligand (i.e. drug candidate) takes place (or not), and/or determining whether bound or free states of a putative drug candidate predominate. In particular, the binding data may comprise information about a binding and/or a binding state and/or a binding strength of the ligand to a target molecule. Target molecules (e.g. a biomolecule such as a protein and/or enzyme, DNA/RNA) may be present in the prepared sample, i.e., already before hyperpolarizing the sample. Alternatively or in addition, the target molecules may be mixed into the sample after hyperpolarizing (and particularly liquefying) the sample. In particular, after hyperpolarizing the sample, the sample may be liquefied. Alternatively or in addition, after hyperpolarizing the sample, the sample may be dissolved in a solution which contains the target molecules.

One of the advantages of the method according to the present invention is that by means of this method one can very quickly determine the affinity of a drug candidate towards a protein target with a relatively inexpensive instrument. Moreover, the method according to the present invention requires a smaller amount of both drug candidate and protein to determine the affinity compared to conventional methods. In particular, the determination of ligand affinity (as opposed to a mere yes/no determination of whether binding takes place) may be based on a titration experiment of either the ligand or the protein concentration employing concentrations from 0.1 KD to 10 KD, where KD is the dissociation binding constant. While fragments and weak binders have KDs of the order of 100 uM or more, strong binders have KDs in the nanomolar range. The ability of the method to detect binding using low ligand concentrations therefore enables an NMR based determination of binding affinity for strong binders. And the method according to the present invention is very broadly applicable. In particular, the method according to the present invention combines hyperpolarization (e.g. to boost the sensitivity for $^{13}$C, $^1$H and/or $^{19}$F detection) and low-field NMR (particularly $T_1$) measurement (to generate high contrast between the relaxation rates of free and bound ligand). The detection of the low-field longitudinal relaxation time $T_1$ can advantageously be carried out both at low magnetic field (e.g. 1 T) and at high magnetic field (e.g. 10 T). Within the present description, a low magnetic field may be a magnetic field between 10 mT and 5 T. Consequently, within the present description, a high magnetic field may be a magnetic field larger than 5 T. In particular, a low magnetic field may be a magnetic field between 10 mT and 3 T, or between 10 mT and 2 T, or between 10 mT and 1,5 T, or between 10 mT and 1,3 T, or between 10 mT and 1,0 T. Consequently, within the present description, a high magnetic field may be a magnetic field larger than 3 T and/or larger than 2 T and/or larger than 1,5 T and/or larger than 1,3 T and/or larger than 1,0 T. Magnetic fields below 10 mT, however, are not considered relevant for the present invention.

Within the present invention, it turned out that compared to the magnetic fields applied in conventional high-field NMR a lower magnetic field would be more economic, but this low magnetic field is not sensitive enough for drug screening. By means of hyperpolarizing the sample, however, the sensitivity is boosted and thus makes a low magnetic field viable. In conventional drug screening methods, the $T_2$-relaxation or NOE (Nuclear Overhauser Effect) measurements at high magnetic field are used as proxies for the rotational diffusion $\tau_c$ and are standard for the past 20 years. In particular, $T_2$-relaxation and NOE-relaxation are separate yet likewise genuine contrast mechanisms that can reveal binding. $T_2$-relaxation and NOE measurements at high magnetic field are limited to relaxation times < 1 s. Using the $T_1$-relaxation at low magnetic field, enabled by hyperpolarization (such as dynamic nuclear polarization) offers at least one order of magnitude more contrast for the binding detection. Moreover, relaxation times of up to a minute are possible. Compared to conventional methods, where usually about 200 uM ligand and about 20 uM protein is required, and where the measurement time is about 10 to 20 minutes, the present invention enables an approximately 10-fold enhanced binding contrast and allows the reduction of sample volumes and measurement time. Hence, working with lower sample volumes and reduced masses of protein and ligand is possible, thereby reducing cost. Moreover, a higher throughput is possible. Apart from that, thanks to low field relaxation, not only $^1$H or $^{19}$F can be used, but also [13]C. $^{13}$C can be used either by using a $^{13}$C labelled compound, in particular for competitive binding experiments, or it can be used at natural abundance (as hyperpolarization boosts the signal strength typically by a factor of at least $10^4$.)

In a preferred embodiment, hyperpolarizing the sample is carried out by dynamic nuclear polarization (DNP) and particularly by bullet dynamic nuclear polarization. It is noted in this respect that within the present invention, it turned out that other hyperpolarization methods are in principle suitable but are in general less universal with respect to the chemical variety of putative drugs and/or less suitable for small sample volumes. In DNP, microwave irradiation is used to transfer polarization from electron spins to nuclear spins. The microwave irradiation enhances the polarization of the nuclei by exciting either forbidden electron-nuclear transitions (known as the solid effect) or by partially saturating electron spins in such a way that ensuing electron-electron-nuclear triple-spin-flips can only drive the nuclear polarization towards +1 or - 1 (known as thermal mixing or cross effect DNP). Subsequently, nuclear spin diffusion spreads the nuclear polarization evenly across the sample, leading to a significant increase in the average nuclear polarization.

In a further preferred embodiment, the low-field nuclear magnetic resonance measurement is a low-field nuclear

magnetic resonance $T_1$-measurement. Alternatively or in addition, performing a low-field nuclear magnetic resonance measurement (particularly a low-field nuclear magnetic resonance $T_1$-measurement) comprises determining a relaxation time $T_1$ and/or a relaxation rate $R_1$, particularly of $^{13}C$, $^{1}H$ and/or $^{19}F$ nuclei, the relaxation time $T_1$ and/or the relaxation rate $R_1$ being a measure for the binding strength of the at least one ligand (with respect to a target molecule). In particular, $^{13}C$ nuclei are used for the present invention. As already mentioned, $^{13}C$ can be used either using a $^{13}C$ labelled compound, in particular for competitive binding experiments, or it can be used at natural abundance. This is possible since $^{13}C$ hyperpolarization boosts the signal strength typically by a factor of 10000).

In a further preferred embodiment, the low-field nuclear magnetic resonance measurement is a low-field nuclear magnetic resonance $T_1$-measurement, wherein performing a low-field nuclear magnetic resonance $T_1$-measurement comprises performing a low-field $T_1$ evolution by keeping the sample at a low magnetic field for a variable evolution time, wherein the low magnetic field does preferably not exceed 5 Tesla, more preferably 3 Tesla, more preferably 2 Tesla, more preferably 1,5 Tesla, more preferably 1,3 Tesla and particularly 1,0 Tesla, and/or wherein the low magnetic field is particularly of the order of 1 Tesla. Preferably, the evolution time is varied, because there may be substantial uncertainty with respect to the initial magnetization. By varying the evolution time, data is obtained that can be fitted to an exponential decay, and the time constant of this decay is $T_1$. The relaxation time $T_1$ may be determined or inferred from a single measurement (particularly if sufficient repeatability of the hyperpolarization process is achieved). In any case, the evolution time is preferably varied in the vicinity of the $T_1$ time constant. For example, if $T_1$ is estimated to be 2 s, a single measurement with an evolution time of 2 s may be carried out. If the evolution time is varied, the evolution times may be chosen of, for example, (0 s, 0,5 s, 1 s, 2 s, 5 s, and 10 s).

As already mentioned above, within the present description, the term "low magnetic field" may be a magnetic field as low as 100 mT or even 10 mT. Fields below 10 mT, however, are not considered relevant for the present invention. Therefore, magnetic fields below 10 mT do particularly not fall under the term "low magnetic field" within the present description, but rather relate to "ultra-low magnetic fields" that are used, e.g., by zero to ultra-low field (ZULF) NMR.

In a further preferred embodiment, performing a low-field nuclear magnetic resonance measurement (particularly a low-field nuclear magnetic resonance $T_1$-measurement) comprises detecting a decay of a nuclear magnetic resonance signal at the low magnetic field. This can be done, for instance, inside a low-field NMR apparatus or in the low-field region of a (superconducting) high-field magnet (with a field at its centre in the order of 10 T). Since due to hyperpolarization, the magnetization of the nuclei is much larger than at thermal equilibrium (usually by 2 to 6 orders of magnitude), it is advantageously possible to measure $T_1$ simply by observing the decay of the large magnetization, e.g. by using small flip angle pulses. This reduces the complexity of the measurement setup and thus also costs. In particular, there is no need for a high-field NMR apparatus for carrying out the $T_1$-measurement(s).

In a further preferred embodiment, detecting a decay of a nuclear magnetic resonance signal is performed by shuttling the hyperpolarized sample between low-field and high-field regions of a high-field nuclear magnetic resonance apparatus, or by detecting an entire decay curve while keeping the sample at a low magnetic field that does not exceed 5 Tesla.

In a further preferred embodiment, after hyperpolarizing the sample, the sample is transferred (and/or ejected) towards an injection device that is located in a high-field nuclear magnetic resonance apparatus. Within the present description, the term "high-field" particularly means a magnetic field of the order of 10 Tesla.

In a further preferred embodiment, before performing the low-field nuclear magnetic resonance measurement (particularly the low-field nuclear magnetic resonance $T_1$-measurement), the hyperpolarized sample is dissolved in a solution containing a drug target. In particular, the drug target (or receptor) comprises or is a biomolecule such as a protein, enzyme, RNA and/or DNA

In a further preferred embodiment, performing a low-field nuclear magnetic resonance measurement (particularly low-field nuclear magnetic resonance $T_1$-measurement) comprises repeatedly transferring small amounts of the solution including the dissolved sample to a detector in a high magnetic field for reading out a nuclear magnetic resonance signal (which particularly serves to determine the relaxation time $T_1$ and/or the relaxation rate $R_1$). It is noted that transferring only small amounts of the solution including the dissolved sample to a detector would not be possible in a scenario where the sample has to be deposited in sealed sample compartments.

According to a further aspect of the present invention, a system for drug screening by means of nuclear magnetic resonance is provided, the system comprising:

- a sample preparation unit for preparing a sample containing at least one ligand being a putative drug candidate or a fragment thereof;
- a polarizer for hyperpolarizing the sample;
- a nuclear magnetic resonance apparatus configured to perform a low-field nuclear magnetic resonance measurement; and
- an evaluation unit configured to determine binding data of the at least one ligand based on a low-field nuclear magnetic resonance measurement.

Preferably, the nuclear magnetic resonance apparatus is configured to perform a low-field nuclear magnetic resonance $T_1$-measurement. Further preferably, the evaluation unit is configured to determine binding data of the at least one ligand based on a low-field nuclear magnetic resonance $T_1$-measurement. In particular, the polarizer for hyperpolarizing the sample and the nuclear magnetic resonance apparatus may be different entities. In this case, the sample has to be transferred from the polarizer to the nuclear magnetic resonance apparatus in order to perform the low-field nuclear magnetic resonance measurement (particularly the low-field nuclear magnetic resonance $T_1$-measurement).

In a preferred embodiment, the polarizer comprises or is a DNP (dynamic nuclear polarization) unit, and particularly a bullet-DNP unit. In particular, the DNP unit comprises a microwave source to provide energy for transferring polarization from (unpaired) electrons to nuclear spins.

In a further preferred embodiment, the nuclear magnetic resonance apparatus is a low-field nuclear magnetic resonance apparatus. In particular, in the nuclear magnetic resonance apparatus only low magnetic fields (> 5 T) are used and/or generated. Concerning the definition of "low magnetic fields", reference is made to the previous explanation as to the understanding of a "low magnetic field" within the present description.

In a further preferred embodiment, the sample preparation unit comprises an automatic loader configured to automatically insert the sample into the polarizer. Advantageously, the automatic loader (also referred to herein as "autoloader") is configured to perform operations without "human hands". In particular, the autoloader is configured to carry out one or more of the following steps:

- prepare the sample to be polarized as a liquid solution;
- pipet a specified amount of this solution, i.e. a liquid solution containing the sample, into a bullet (the bullet particularly being a small plastic bucket made from ultra-high molecular weight polyethylene);
- freeze the solution (e.g. by means of liquid nitrogen) in such a way that the liquid stays inside the bullet until it is frozen; and
- load the frozen bullet into the polarizer, wherein the autoloader particularly ensures that no air enters the polarizer (this serves to prevent a possible blockage, e.g. of tubes, since air can freeze inside the polarizer and lead to such a blockage).

One or more of the above-mentioned steps carried out by the autoloader may be part of the method for drug screening by means of nuclear magnetic resonance, as described herein.

In a preferred embodiment, the autoloader comprises one or more of the following:

- a sealed chamber;
- a bullet feed for providing one or more bullets;
- a bullet receptacle for receiving and/or mounting a bullet (particularly an empty bullet);
- a pipetting robot for filling the (empty) bullet with the (liquid) sample;
- cooling means for colling the bullet receptacle (and thus the bullet located in the bullet receptacle and/or sample located inside the bullet), wherein the cooling means particularly comprise a liquid nitrogen reservoir and/or a liquid nitrogen supply pipe for delivering liquid nitrogen to the bullet receptacle, and/or a pump for pumping liquid nitrogen through the supply pipe and/or through the bullet receptacle; and
- an airlock loading unit (also referred to herein as "airlock" or "airlock means") for loading the sample into the polarizer without bringing air into the polarizer, the airlock loading unit particularly comprising a tee piece with three ports (in particular a top port, a side port and a bottom port).

In particular, the autoloader is configured to carry out one or more of the following steps:

- placing an empty bullet inside the bullet receptacle (particularly a block, e.g. made from aluminium);
- filling the liquid sample into the bullet receptacle (using the pipetting robot); and
- pumping liquid-nitrogen through the bullet receptacle (thereby causing it to cool down and the sample to freeze).

These steps are preferably carried out in nitrogen atmosphere in order to prevent condensation of water. The sample is then transferred (particularly shot) into the airlock. For finally loading the sample into the polarizer, the top port and the side port of the airlock are opened and the bottom port is closed. After arrival of the sample inside the airlock, the top port is closed, and the tee piece is evacuated and flushed with a gas (preferably helium) via the side port. Then, the bottom port is opened, and the sample drops and/or is propelled into the polarizer. One or more of the above-mentioned steps carried out by the autoloader may be part of the method for drug screening by means of nuclear magnetic resonance, as described herein.

A further aspect of the present invention relates to the use of the system according to the present invention for drug screening. In particular, binding data of the ligand is determined based on a low-field nuclear magnetic resonance measurement (particularly low-field NMR $T_1$-measurement). Alternatively or in addition, the system according to the present invention may be used for other NMR experiments (e.g. for metabolomics, i.e. the examination of biological samples for their material composition).

For the above mentioned further independent aspect and in particular for preferred embodiments in this regard, the explanations given above or below concerning the embodiments of the first aspect also hold true. In particular, for one independent aspect of the present invention and for preferred embodiments in this regard, the explanations given above and below concerning the embodiments of the respective other aspects also hold true.

Individual embodiments for solving the problem are described by way of example below with reference to the figures. In this case, the individual embodiments described have in part features which are not absolutely necessary for implementing the claimed subject matter, but which provide desired properties in specific applications. In this regard embodiments which do not have all the features of the embodiments described below are also intended to be regarded as disclosed in a manner falling under the technical teaching described. Furthermore, in order to avoid unnecessary repetitions, specific features are mentioned only with regard to individual embodiments from among the embodiments described below. It is pointed out that the individual embodiments are therefore intended to be considered not only by themselves but also in a joint consideration. On the basis of this joint consideration the person skilled in the art will recognize that individual embodiments can also be modified by inclusion of individual or a plurality of features of other embodiments. It is pointed out that a systematic combination of the individual embodiments with individual or a plurality of features described with regard to other embodiments may be desirable and expedient and is therefore intended to be taken into account and also to be regarded as encompassed by the description.

Brief description of the figures

The above and other objects, features and advantages of the present invention will become more apparent upon reading of the following description of preferred embodiments and accompanying drawings. Other features and advantages of the subject-matter described herein will be apparent from the description and the drawings and from the claims. It should be understood that even though embodiments are separately described, single features and functionalities thereof may be combined without prejudice to additional embodiments. The present disclosure is illustrated by way of example and not limited by the accompanying figures.

Preferred embodiments of the present invention are exemplarily described regarding the following figures:

Fig. 1 shows a simulation of the longitudinal relaxation Rate $R_1$ in dependence of the correlation time for $^{13}$C at a magnetic field of 1 T and 10 T, wherein typical correlation times are indicated for a ligand L and a protein-ligand complex PL by arrows;

Fig. 2 shows a block diagram with steps that are carried out by a method and/or system according to an exemplified embodiment of the present invention;

Fig. 3 shows a schematic representation of a system 100 according to an exemplified embodiment of the present invention.

Detailed description of the figures

The following detailed description relates to exemplary embodiments of the present invention. Other embodiments of the invention are possible within the scope of the invention as defined by the appended claims. Throughout the figures, same reference signs are used for the same or similar elements.

It turned out by the present invention that hyperpolarization methods like dynamic nuclear polarization (DNP) and its variants dissolution-DNP and bullet-DNP boost the signal strength of NMR so that it is possible to carry out a low-field NMR detection. This is because the high polarization provided by DNP can offset the otherwise low sensitivity of low-field NMR. Hyperpolarization methods work best for low-$\gamma$ nuclei such as $^{13}$C. In addition to sufficient sensitivity, drug-screening requires contrast, i.e., a physical parameter accessible to measurement has to change upon binding. A key parameter for binding is the correlation time. In short, a small free ligand molecule is very free to reorient quickly, and has a correlation time of typically $\tau_L = 100$ ps. For a protein, the correlation time increases with size. As a rule of thumb, the correlation time of a protein is

$$\tau_P \sim 0{,}6 \, m_P \frac{\mathrm{ns}}{\mathrm{kDa}} \qquad (1),$$

wherein $m_P$ is the protein mass (in kDa). For a 15 kDa protein, $\tau_P \sim$ 10 ns. Upon binding, the ligand moves with the protein, and therefore attains (approximately) the correlation time of the protein for as long as it is bound. NMR measures correlation times $\tau$ only indirectly, via the nuclear $T_1$. The relaxation rate $R_1 = 1/T_1$ due to the molecular motion is given by

$$R_1 = \frac{\gamma^2 B_r^2 \tau}{1 + \omega^2 \tau^2} \qquad (2),$$

wherein, $B_r$ describes a random field (due to random motions in the sample), and wherein $\omega = -\gamma B_0$ is the nuclear Larmor frequency. The quantity $\gamma$ is the gyromagnetic ratio (a constant for a given nucleus), and $B_0$ is the applied magnetic field.

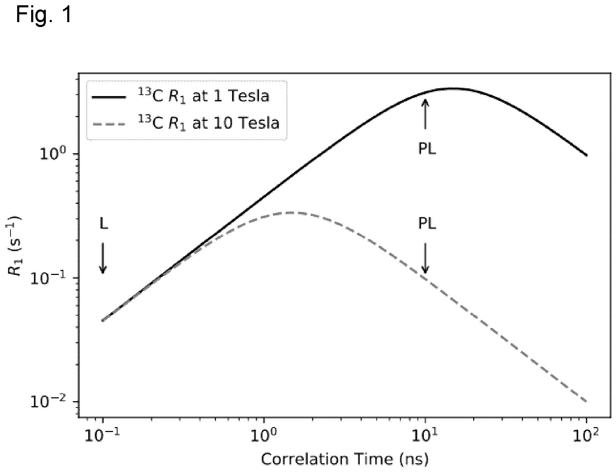

**Fig. 1** shows a simulation of the longitudinal relaxation Rate $R_1$ in dependence of the correlation time for $^{13}$C at a magnetic field of 1 T and 10 T, wherein typical correlation times are indicated for a ligand L and a protein-ligand complex PL by arrows. In Fig. 1 the rate $R_1$ is shown for $^{13}$C and a $B_r$ amplitude of 100 nT for low magnetic field (1 Tesla, continuous curve) and high magnetic field (10 Tesla, dashed curve). At a typical NMR field of 10 T (dashed line), the $R_1$ values are almost equal, making it impossible to detect binding by $^{13}$C $R_1$ observation. On the other hand, at low magnetic field (for example 1 T, see the continuous line in Fig. 1) the $R_1$ values for L and PL differ by almost two orders of magnitude, providing excellent contrast for the detection of binding.

Thus, for drug screening, the relaxation rate of a drug molecule may be observed and/or measured. In particular, the measured relaxation rate $\overline{R_1}$ of the ligand L is the weighted average of the relaxation rate $R_1^L$ of the free ligand (having a concentration [L]) and the relaxation rate $R_1^{PL}$ of the ligand L bound to, e.g., a protein (with the complex being present at a concentration [PL]):

$$\overline{R_1} = \frac{R_1^L [L] + R_1^{PL} [PL]}{[L] + [PL]} \qquad (3).$$

Binding can therefore be detected only when $R_1^{PL} \neq R_1^L$. In order to detect weak binding, i.e., [PL] $\ll$ [L], a high contrast is required, e.g. $R_1^{PL} \gg R_1^L$.

The contrast can be written as

$$\frac{R_1^L}{R_1^{PL}} = \frac{\dfrac{\gamma^2 B_r^2 \tau_L}{1 + \omega^2 \tau_L^2}}{\dfrac{\gamma^2 B_r^2 \tau_{PL}}{1 + \omega^2 \tau_{PL}^2}} = \frac{\tau_L}{\tau_P} \frac{\omega^2 \tau_{PL}^2 + 1}{\omega^2 \tau_L^2 + 1} \qquad (4).$$

The contrast defined in equation (4) is maximal when

$$\omega^2 \tau_{PL} \gg 1 \qquad (5)$$

or

$$\omega^2 \tau_{PL} \ll 1 \qquad (6).$$

It can be seen in Fig. 1 that the relaxation rates for the free ligand L and the complex PL (protein and ligand) are almost equal at 10 Tesla. Hence, at a high magnetic field of e.g. 10 Tesla one cannot tell from a $^{13}$C $T_1$-measurement whether binding takes place or not. This is because the contrast defined in equation (4) is relatively low at a high magnetic field. At a low magnetic field of e.g. 1 Tesla, however, equation (6) is fulfilled, and the contrast between protein P and ligand L amounts to almost two orders of magnitude. Hence, at a low magnetic field of e.g. 1 Tesla, the contrast defined in equation (4) is relatively high, and thus it is possible to determine from a $^{13}$C $T_1$-measurement whether binding takes place or not. In particular, it turned out within the present invention that NMR drug screening is possible when using low magnetic fields for a $T_1$-evolution.

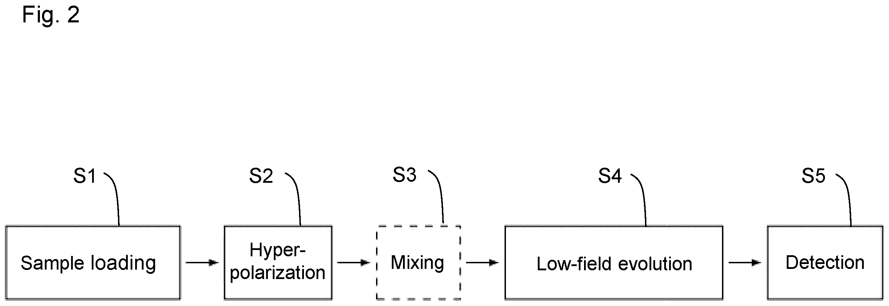

**Fig. 2** shows a flow diagram for explaining an exemplified embodiment of the present invention, which enables to observe a good contrast between bound and free states of a putative drug molecule. The flow diagram comprises steps S1 to S5, wherein step S3 is optional and thus displayed with a box having a dashed border. In step S1, one or more samples are prepared and loaded, particularly by means of a sample preparation unit and/or sample loader, into a polarizer for hyperpolarizing the one or more samples. The sample loader can either be a person that loads the one or more samples manually into the polarizer, or a device that does so automatically. The polarizer for hyperpolarizing at least one sample can be a conventional dissolution-DNP polarizer or a bullet-DNP instrument. If the protein P is included in the sample prepared by the sample loader, liquefying the sample is sufficient. Otherwise, i.e. if the protein P is not included in the sample prepared by the sample loader, the sample needs to be liquefied (e.g. by dissolution with a solvent) and mixed with a solution containing the protein (optional step S3). The sample is then kept at a low magnetic field (of the order of 1 Tesla) for a variable time. Such a low-field evolution, which is shown as step S4 in Fig. 2, can be carried out inside a low-field NMR apparatus, or in the low-field region of a superconducting high-field magnet (with a magnetic field of the order of 10 Tesla). In step S5, the decay of the NMR signal at low magnetic field is detected. For example, the detection can be carried out by shuttling the sample between high and low magnetic field regions, or by detecting the entire decay curve while keeping the sample at a low magnetic field.

In particular, as shown in Fig. 2, a sample containing a drug candidate is prepared and loaded into a polarizer (step S1). By means of the polarizer, the sample and particularly the nuclear spins therein are hyperpolarized (step 2). The sample is then removed from the polarizer and liquefied. The sample may already contain the target protein, or optionally the liquid (liquefied sample) may get mixed with another solution containing the target protein (step S3). The solution containing the hyperpolarized drug candidate and the protein is then evolved at a low magnetic field (step S4), and the magnetic resonance signal is detected (step S5). In particular, with the hyperpolarized sample, a low-field nuclear magnetic resonance $T_1$-measurement is carried out in steps S4 and S5. Based on the low-field nuclear magnetic resonance $T_1$-measurement, binding data of the ligand L can be determined.

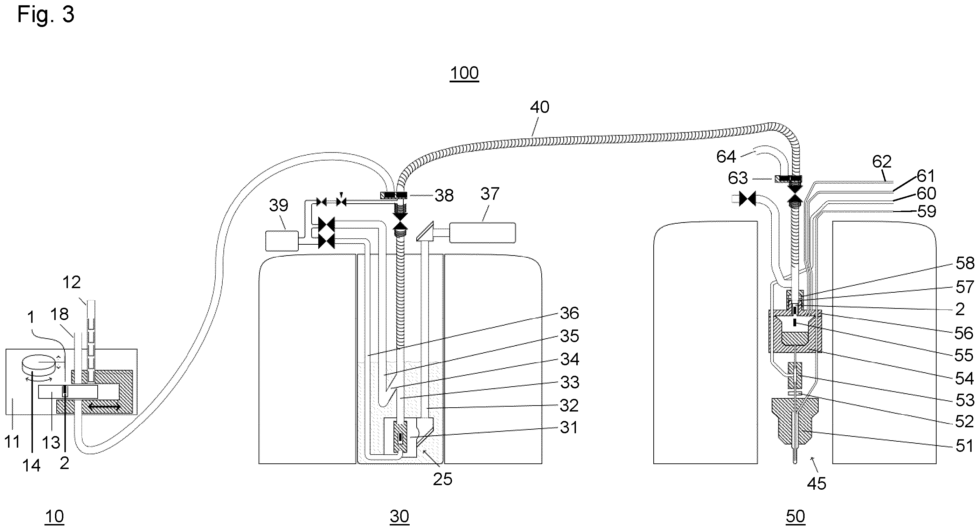

**Fig. 3** shows a schematic representation of a system 100 according to an exemplified specific embodiment of the present invention. The system 100 comprises an autoloader 10, a polarizer 30 and a liquid-state NMR instrument 50. The autoloader 10 is used to prepare samples 1 containing putative drug candidates, and to insert these samples 1 into a bullet-DNP polarizer 30. Inside the polarizer 30, the samples 1 and particularly nuclear spins of the drug candidate are hyperpolarized. A hyperpolarized sample 1 is then ejected towards an injection device that is located in the NMR instrument 50. Inside the NMR instrument 50, the hyperpolarized sample 1 may be dissolved in a solution containing the target protein. This solution (including the dissolved sample) is kept at a low magnetic field of approximately 1 Tesla for a variable wating or evolution time, so that binding of the drug candidate to the target protein leads to fast relaxation. In other words, the sample 1 is kept in a solvent reservoir 54 inside the liquid-state NMR instrument 50 for a variable evolution time. After a predetermined waiting time, the solution (including the dissolved sample) is injected into an NMR tube assembly 51, and the remaining NMR signal is detected. In particular, a reduction in signal strength (e.g. upon increasing the concentration of a protein) is a measure for the strength of the binding.

In order to provide a cost-effective and fast system, the NMR instrument 50 is preferably a low magnetic field NMR instrument used for the detection of the NMR signal. In this case, the decay of the magnetization can be measured in real time and/or can be determined from a fit of the decay curve. Alternatively, a (small) NMR detector located at a high magnetic field (e.g. of the order of 10 Tesla) may be used, and (small) parts of the solution may be transferred repeatedly from the reservoir 54 at low magnetic field to the (small) NMR detector located at a high magnetic field for reading out the NMR signal. In this way, the decay which evolves at low magnetic field (e.g. of the order of 1 Tesla) can advantageously be measured at high magnetic field (e.g. of the order of 10 Tesla), thereby further increasing the sensitivity.

The autoloader 10 shown in Fig. 3 comprises a sealed chamber 11 which is filled with nitrogen gas having a pressure larger than 1 bar. The autoloader 10 further comprises a bullet feed 12 for providing one or more bullets 2, an aluminium block 13 serving as a bullet receptacle for receiving and/or mounting a bullet 2, a pipetting robot 14 for filling an empty bullet 2 with the (liquid) sample 1, a helium supply pipe 18, and cooling means (not explicitly shown in Fig. 3) for colling the bullet receptacle 13 (and thus the bullet 2 located in the bullet receptacle 13 and/or the sample 1 located inside the bullet 2). The helium supply pipe 18 is used to supply helium gas from the top to push the bullet 2 out of the bottom of a moving arm into the polarizer 30 (the movement is indicated in Fig. 3 by double arrows). As shown in Fig. 3, the moving arm is placed for filling the bullet 2 with liquid. After freezing the arm will move to the left for shooting the bullet 2 into the polarizer 30. The arm will then move further to the left and one bullet 2 will drop from the supply tube 12 into the receptacle 13, after which the arm will move by two increments to the right, enabling filling. The cooling means may comprise a liquid nitrogen reservoir and/or a liquid nitrogen supply pipe for delivering liquid nitrogen to the bullet receptacle 13, and/or a pump for pumping liquid nitrogen through the supply pipe and/or through the bullet receptacle 13. Moreover, the autoloader 10 comprises an airlock (not explicitly shown in Fig. 3) for loading the sample 1 into the polarizer 30 without bringing air into the polarizer 30, wherein the airlock comprises a tee piece with three ports, namely a top port, a side port and a bottom port. The airlock may be placed anywhere between the auto loader 10 and the polarizer 30. For example, the airlock may be installed on top of the polarizer 30.

In particular, the autoloader 10 is part of a sample preparation unit and configured to automatically insert the sample 1 into the polarizer 30 without "human hands". For this purpose, the autoloader 10 is configured to place an empty bullet 2 inside the bullet receptacle 13, fill the liquid sample 1 into the bullet receptacle 13 by using the pipetting robot 14, and pump liquid-nitrogen through the bullet receptacle 13, thereby causing it to cool down and the sample 1 to freeze. These steps are preferably carried out in nitrogen atmosphere in order to prevent condensation of water. The sample 1 is then shot into the airlock. For finally loading the sample 1 into the polarizer 30, the top port and the side port of the airlock are opened, and the bottom port is closed. After arrival of the sample 1 inside the airlock, the top port is closed, and the tee piece is evacuated and flushed with a gas (particularly helium) via the side port. Then, the bottom port is opened and the sample 1 drops and/or is propelled into the polarizer 30.

The polarizer 30 shown in the embodiment of Fig. 3 is a bullet-DNP unit. The bullet-DNP unit 30 comprises a cryogen-free magnet 25 hosting a DNP insert 25. The DNP insert 25 uses two pipes to supply helium gas received from a helium gas source 39 and used to propel the sample 1, namely a pilot gas pipe 36 used to lift the sample 1 out of the isothermal zone of the cryostat and a main gas pipe 35 for applying a substantially larger helium gas flow. The main gas pipe 35 is connected to a bullet tunnel 33 via a junction 34 in such a way that the helium flow is directed upwards as it enters the bullet tunnel 33. The bullet-DNP unit 30 comprises a microwave source 37 and a microwave guide 32 for providing microwaves to the sample 1 which is positioned in a cavity 31. The microwaves provided by the microwave source 37 enable the transfer of polarization from electron spins to nuclear spins. In other words, the microwave source 37 provides the necessary energy to excite electron-nuclear spin transitions, enabling the transfer of polarization from electrons to nuclei.

A magnetic tunnel 40 connects the DNP insert 25 to an injection device 45 of the NMR apparatus 50. In order to preserve the nuclear spin polarization, a solenoid that is wound around the entire magnetic tunnel 40 is energized for the sample transfer. A solvent is filled into a solvent reservoir 54 via a solvent pipe 62. A ball valve (shown between two sections of the magnetic tunnel 40) is opened and the bullet 2 is ejected from the DNP insert 25. The bullet 2 arrives via a central steel tube and comes to a stop at a constriction in a solvent reservoir lid 56. The hyperpolarized solid 55 passes through this constriction and dissolves in the solvent upon impact. The solvent reservoir 54 is pressurized by helium gas that is provided by means of a helium gas pipe 61, and a pinch valve 53 is opened (by means of a pinch valve control 60), thereby causing the liquid to flow into an NMR tube assembly 51 via its inner capillary. After another delay, back pressure is applied to a waste pipe 59 of the NMR tube assembly 51 and NMR acquisition is started. A small adaptor piece 57 connects the solvent reservoir lid 56 to the main steel tube that connects to the top of the injection device 45. To detect the arrival of the bullet 2, optical detectors 52 and 58 are used. The empty bullet 2 may be ejected after the experiment by moving the switch 63 to the eject position and pressurizing the solvent reservoir 54 in order to eject the empty bullet 2 via the ejection line 64.

In summary, NMR based drug screening is concerned with the detection of binding of a small molecule (the drug candidate or a fragment thereof) to a protein target. The methodology is typically implemented at intermediate magnetic fields. The sensitivity of these experiments and thereby the throughput and/or scope can be enhanced using hyperpolarization methods. A broadly applicable method is dynamic nuclear polarization and particularly dissolution-dynamic nuclear polarization or bullet-dynamic nuclear polarization. Both these methods can hyperpolarize nuclei to levels of tens of percents, leading to signals which are 2 to 6 orders of magnitude larger than their thermal equilibrium counterparts. However, at intermediate fields, the nuclei that work best for hyperpolarization techniques (low-gamma nuclei like $^{13}$C) do not show a strong dependence of relaxation time upon the binding state of the ligand. It is therefore hard to observe whether the molecule binds to a protein or not. At low magnetic fields and for low-gamma nuclei, however, the spectral density function that governs relaxation depends strongly on the size of the molecule, so that binding can easily be detected, provided that the signal is strong enough. In particular, it turned out by the present invention that by combining low-field NMR or low-field NMR spectroscopy with DNP, one obtains the best of both worlds, the sensitivity of DNP experiments, combined with the contrast available in low-field NMR experiments.

Within the present description, a combination of hyperpolarization by DNP with low-field NMR detection is provided. The throughput may be increased further by automatically loading samples from a pipetting system or pipetting robot 14 into the DNP polarizer 30. The DNP polarizer 30 may be a conventional dissolution-DNP system or, as shown in Fig. 3, a bullet-DNP system. The DNP polarizer 30 may be connected to a low-field NMR system 50 using a transfer path 40, through which the sample 1 is transferred either as a liquid (conventional dissolution-DNP) or as a solid (bullet-DNP).

In particular, the present invention offers accelerated NMR based drug screening. A possible product may be a complete detection system (comprising an autoloader 10 to supply samples 1 to the polarizer 30, the polarizer 30, and the low-field NMR detection system 50).

In particular, preferred embodiments of the present invention have one or more of the following features and/or advantages:

- Enhancement of binding contrast via a low-field stage;
- Increase of sensitivity by bullet DNP (other hyperpolarization methods are in principle suitable but are in general less universal with respect to the chemical variety of putative drugs) or less suitable for small sample volumes;
- Extension of drug discovery experiments to $^{13}$C;

- Enhancement of binding contrast without a decrease in sensitivity;
- Automated screening with DNP-based hyperpolarization.

In particular, with the present invention, it is possible to test several potential drug candidates (ligands) without a complicated field-cycling instrument. By means of hyperpolarizing the sample, particularly by means of DNP, the method and system described herein become highly sensitive and fast, so that they can be used to perform drug screening at scale, which is not possible with conventional NMR based drug screening methods and/or systems.

**List of Reference Numerals**

| | |
|---|---|
| 1 | sample |
| 2 | bullet |
| 10 | autoloader (automatic loader) |
| 11 | chamber |
| 12 | bullet feed |
| 13 | aluminium block (bullet receptacle) |
| 14 | pipetting robot |
| 18 | helium gas supply pipe |
| 25 | DNP insert |
| 30 | polarizer (hyperpolarization means) |
| 31 | cavity |
| 32 | microwave guide |
| 33 | bullet tunnel |
| 34 | junction |
| 35 | main gas pipe |
| 36 | pilot gas pipe |
| 37 | microwave source |
| 38 | switch |
| 39 | helium gas source |
| 40 | magnetic tunnel |
| 45 | injection device |
| 50 | liquid-state NMR instrument (NMR apparatus) |
| 51 | NMR tube assembly |
| 52 | optical detector |
| 53 | pinch valve |
| 54 | heatable solvent reservoir |
| 55 | hyperpolarized solid |
| 56 | solvent reservoir lid |
| 57 | Kel-F adapter |
| 58 | optical detector |
| 59 | waste pipe |
| 60 | pinch valve control |
| 61 | helium gas pipe |
| 62 | solvent pipe |
| 63 | switch |
| 64 | bullet ejection |
| 100 | system |
| L | ligand |
| PL | protein-ligand complex |

**Claims**

1. A method for drug screening by means of nuclear magnetic resonance, comprising:

   - preparing a sample (1) containing at least one ligand (L), the ligand being a putative drug candidate or a fragment thereof;

- hyperpolarizing the sample (1);
- performing, with the hyperpolarized sample (1), a low-field nuclear magnetic resonance measurement; and
- determining binding data of the ligand (L) based on the low-field nuclear magnetic resonance measurement.

2. The method according to claim 1, wherein hyperpolarizing the sample (1) is carried out by dynamic nuclear polarization and particularly by bullet dynamic nuclear polarization.

3. The method according to claim 1 or 2,

wherein the low-field nuclear magnetic resonance measurement is a low-field nuclear magnetic resonance $T_1$-measurement, and/or
wherein performing a low-field nuclear magnetic resonance measurement comprises determining a relaxation time $T_1$ and/or a relaxation rate $R_1$, particularly of $^{13}C$, $^1H$ and/or $^{19}F$ nuclei, the relaxation time $T_1$ and/or the relaxation rate $R_1$ being a measure for the binding strength of the at least one ligand (L)

4. The method according to any one of the preceding claims,

wherein the low-field nuclear magnetic resonance measurement is a low-field nuclear magnetic resonance $T_1$-measurement, and
wherein performing a low-field nuclear magnetic resonance $T_1$-measurement comprises performing a low-field $T_1$ evolution by keeping the sample (1) at a low magnetic field for a variable evolution time, wherein the low magnetic field does preferably not exceed 5 Tesla, more preferably 3 Tesla, more preferably 2 Tesla, more preferably 1,5 Tesla, more preferably 1,3 Tesla and particularly 1,0 Tesla, and/or wherein the low magnetic field is particularly of the order of 1 Tesla.

5. The method according to any one of the preceding claims, wherein performing a low-field nuclear magnetic resonance measurement comprises detecting a decay of a nuclear magnetic resonance signal at the low magnetic field.

6. The method according to claim 5, wherein detecting a decay of a nuclear magnetic resonance signal is performed by shuttling the hyperpolarized sample (1) between low-field and high-field regions of a high-field nuclear magnetic resonance apparatus (50), or by detecting an entire decay curve while keeping the sample (1) at a low magnetic field that does not exceed 5 Tesla.

7. The method according to any one of the preceding claims, wherein after hyperpolarizing the sample (1), the sample (1) is transferred towards an injection device (45) that is located in a high-field nuclear magnetic resonance apparatus (50).

8. The method according to any one of the preceding claims, wherein, before performing the low-field nuclear magnetic resonance measurement, the hyperpolarized sample (1) is dissolved in a solution containing a drug target.

9. The method according to claim 8, wherein performing a low-field nuclear magnetic resonance measurement comprises repeatedly transferring small amounts of the solution including the dissolved sample (1) to a detector in a high magnetic field for reading out a nuclear magnetic resonance signal.

10. A system (100) for drug screening by means of nuclear magnetic resonance, comprising:

- a sample preparation unit for preparing a sample (1) containing at least one ligand (L) being a putative drug candidate or a fragment thereof;
- a polarizer (30) for hyperpolarizing the sample (1);
- a nuclear magnetic resonance apparatus (50) configured to perform a low-field nuclear magnetic resonance measurement; and
- an evaluation unit configured to determine binding data of the at least one ligand based on a low-field nuclear magnetic resonance measurement.

11. The system (100) according to claim 10, wherein the polarizer (30) comprises or is a DNP unit, particularly a bullet-DNP unit.

12. The system (100) according to claim 10 or 11, wherein the nuclear magnetic resonance apparatus (50) is a low-field nuclear magnetic resonance apparatus.

13. The system (100) according to any one of claims 10 to 12, wherein the sample preparation unit comprises an automatic loader (10) configured to automatically insert the sample (1) into the polarizer (30).

14. The system (100) according to claim 13, wherein the automatic loader (10) comprises one or more of the following:

- a sealed chamber (11);
- a bullet feed (12) for providing one or more bullets;
- a bullet receptacle (13) for receiving and/or mounting a bullet;
- a pipetting robot (14) for filling the bullet with the sample (1);
- cooling means for colling the bullet receptacle, wherein the cooling means particularly comprise a liquid nitrogen reservoir and/or a liquid nitrogen supply pipe for delivering liquid nitrogen to the bullet receptacle and/or a pump for pumping liquid nitrogen through the supply pipe and/or through the bullet receptacle; and
- an airlock loading unit (16) for loading the sample into the polarizer without bringing air into the polarizer, the airlock loading unit particularly comprising a tee piece with three ports.

15. A use of the system (100) according to any one of claims 10 to 14 for drug screening.

Fig. 1

Fig. 2

| S1 | S2 | S3 | S4 | S5 |
| --- | --- | --- | --- | --- |
| Sample loading | Hyper-polarization | Mixing | Low-field evolution | Detection |

Fig. 3

Europäisches
Patentamt

European
Patent Office

Office européen
des brevets

## PARTIAL EUROPEAN SEARCH REPORT

under Rule 62a and/or 63 of the European Patent Convention.
This report shall be considered, for the purposes of
subsequent proceedings, as the European search report

**Application Number**

EP 25 15 2466

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2023/072083 A1 (HILTY CHRISTIAN [US] ET AL) 9 March 2023 (2023-03-09) | 1-13,15 | INV.<br>G01N24/08 |
| Y | * paragraph [0003] - paragraph [0008] *<br>* paragraph [0042] - paragraph [0054] *<br>----- | 14 | G01R33/28<br>G01R33/44<br>G01R33/46 |
| Y | KRESS THOMAS ET AL: "A novel sample handling system for dissolution dynamic nuclear polarization experiments", MAGNETIC RESONANCE, vol. 2, no. 1, 4 June 2021 (2021-06-04), pages 387-394, XP093313105, ISSN: 2699-0016, DOI: 10.5194/mr-2-387-2021<br>* abstract, the paragraph bridging left and right columns on p.2, first two sub-sections of section "METHODS" on p.6 *<br>----- | 14 | ADD.<br>G01R33/30<br>G01R33/465 |
| | -/-- | | |

**TECHNICAL FIELDS
SEARCHED      (IPC)**

G01N
G01R

### INCOMPLETE SEARCH

The Search Division considers that the present application, or one or more of its claims, does/do not comply with the EPC so that only a partial search (R.62a, 63) has been carried out.

Claims searched completely :

Claims searched incompletely :

Claims not searched :

Reason for the limitation of the search:

see sheet C

| Place of search | Date of completion of the search | Examiner |
|---|---|---|
| Munich | 9 September 2025 | Lebar, Andrija |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons

.......................................................................................

& : member of the same patent family, corresponding
    document

EPO FORM 1503 03.82 (P04E07)

Europäisches
Patentamt

European
Patent Office

Office européen
des brevets

**PARTIAL EUROPEAN SEARCH REPORT**

Application Number

EP 25 15 2466

| | DOCUMENTS CONSIDERED TO BE RELEVANT | | CLASSIFICATION OF THE APPLICATION (IPC) |
|---|---|---|---|
| Category | Citation of document with indication, where appropriate, of relevant passages | Relevant to claim | |
| Y | KAREL KOU\V{R}IL ET AL: "Scalable Dissolution-Dynamic Nuclear Polarization with Rapid Transfer of a Polarized Solid", ARXIV.ORG, CORNELL UNIVERSITY LIBRARY, 201 OLIN LIBRARY CORNELL UNIVERSITY ITHACA, NY 14853, 30 June 2018 (2018-06-30), XP081367848, DOI: 10.1038/S41467-019-09726-5 * abstract, paragraph bridging left and right columns on p.388, section "2 Results and discussion" on pages 388-389, Figs. 2 and 3 * | 14 | |
| | ----- | | |
| | | | **TECHNICAL FIELDS SEARCHED** (IPC) |

EPO FORM 1503 03.82 (P04C10)

page 2 of 2

Claim(s) completely searchable:
-

Claim(s) searched incompletely:
1-15

Reason for the limitation of the search:

The searched subject-matter and the reasons for the restriction are indicated under points 1 and 2 of the European Search Opinion (ESOP).

## ANNEX TO THE EUROPEAN SEARCH REPORT
## ON EUROPEAN PATENT APPLICATION NO.

EP 25 15 2466

This annex lists the patent family members relating to the patent documents cited in the above-mentioned European search report.
The members are as contained in the European Patent Office EDP file on
The European Patent Office is in no way liable for these particulars which are merely given for the purpose of information.

09-09-2025

| Patent document cited in search report | Publication date | Patent family member(s) | Publication date |
|---|---|---|---|
| US 2023072083 A1 | 09-03-2023 | NONE | |

For more details about this annex : see Official Journal of the European Patent Office, No. 12/82